# FASCICULE DE BREVET EUROPEEN

(11) **EP 3 651 190 B1**
(45) Date de publication et mention de la délivrance du brevet: **21.02.2024**
(21) Numéro de dépôt: 19203628.3
(22) Date de dépôt: 16.10.2019
(51) Int. Cl.: H01L 23/00, B23K 1/00, B23K 3/06, B23K 101/42, B23K 103/12

(54) **PROCÉDÉ DE LIAISON PAR BRASAGE PERMETTANT D'AMÉLIORER LA TENUE EN FATIGUE DE JOINTS BRASÉS**
LÖTVERBINDUNGSVERFAHREN, DAS EINE VERBESSERUNG DER ERMÜDUNGSBESTÄNDIGKEIT VON LÖTVERBINDUNGEN ERMÖGLICHT
METHOD FOR CONNECTION BY BRAZING SUITABLE FOR IMPROVING THE FATIGUE RESISTANCE OF BRAZED JOINTS

(30) Priorité: 06.11.2018 FR 1801162
(43) Date de publication de la demande: 13.05.2020
(73) Titulaire: MBDA France, 92350 Le Plessis-Robinson (FR)
(72) Inventeur: CADALEN, Eric, 92358 Le Plessis-Robinson (FR); SATURNIN, Mikaël, 92358 Le Plessis-Robinson (FR)
(74) Mandataire: Gevers & Orès

(56) Documents cités:
- EP-A2- 2 180 505
- US-A- 5 906 312
- JONG-KAI LIN: "LOW THERMO-MECHANICAL STRESS FLIP CHIP BUMPS", MOTOROLA TECHNICAL DEVELOPMENTS, MOTOROLA INC. SCHAUMBURG, ILLINOIS, US, vol. 18, 1 mars 1993 (1993-03-01), pages 76-77, XP000349565, ISSN: 0887-5286

## Description

### DOMAINE TECHNIQUE

La présente invention concerne un procédé de liaison par brasage entre au moins un composant électronique et une carte électronique ou un circuit dédié.

### ÉTAT DE LA TECHNIQUE

On sait que dans des domaines variés, notamment dans le domaine militaire, de plus en plus de dispositifs utilisent pour leur fabrication des composants électroniques dits « grand public », c'est-à-dire qui sont accessibles au grand public et présentent généralement un coût réduit. On peut citer, à titre d'illustration, des composants (ou circuits imprimés) de type QFN (pour « Quad Flat No-leads package » en anglais), BGA (« Ball Grid Array » en anglais), ou WL CSP (pour « Wafer Level Chip Scale Package» en anglais).

Les applications électroniques rencontrées dans le domaine militaire, ainsi que dans les applications grand public, convergent sur quatre points importants de l'électronique, à savoir la recherche de plus de fonctionnalités, de plus de miniaturisation et de plus d'intégration, tout en réduisant les coûts.

Les boîtiers de composants électroniques à bas coûts, issus d'applications grand public, sont ainsi en forte croissance et très répandus. Ils sont avantageux pour les quatre points précités, mais nécessitent une adaptation dans le domaine militaire.

Il est, en effet, nécessaire de prévoir une augmentation de la robustesse pour ces composants, qui ne tiennent pas les environnements sévères susceptibles d'être rencontrés dans le domaine militaire, avec souvent l'apparition de fissures dans les joints brasés en raison d'une fatigue thermomécanique.

Plus particulièrement, ces composants électroniques doivent être en mesure de tenir un nombre suffisant de cycles de température, entre -55°C et +125°C, équivalent à la durée de vie opérationnelle du produit dans lequel ils sont implantés, généralement de l'ordre de 25 ans.

On sait que les paramètres qui influent sur la durée de vie des composants, montés sur un substrat, comprennent notamment la hauteur de joint brasé. Avec les procédés d'assemblage usuels, de type sérigraphie, la hauteur de joint brasé, pour certains composants à bas coûts, tels que des boîtiers de type QFN, est de l'ordre de 50 µm pour un dépôt d'alliage avec un écran de sérigraphie de 150 µm. Cette valeur est le résultat d'expériences accumulées sur la technologie, mais également de compromis liés à l'hétérogénéité des composants montés en surface.

Une des améliorations communes à tous les composants est la hauteur de joint à braser. Plus précisément, si on double la hauteur de joint à braser, pour un composant donné, on multiplie par cinq le nombre de cycles qu'il est en mesure de tenir.

Par conséquent, en augmentant la hauteur des joints à braser, on augmente fortement la robustesse du composant électronique, à savoir la tenue en fatigue thermomécanique des joints brasés de composants sur un substrat.

On connaît différentes solutions usuelles pour augmenter la hauteur des joints brasés, telles que :
- la mise en place de cales ;
- le billage des entrées/sorties ;
- l'optimisation de procédés existant de sérigraphie, par exemple par une augmentation des ouvertures d'écran.

Ces solutions usuelles présentent de nombreux inconvénients. Les inconvénients de ces solutions usuelles sont notamment liés :
- à l'état actuel des procédés avec des capabilités en limite de faisabilité notamment géométriques sur la chaîne de cote en hauteur ;
- à la limitation de la densité d'intégration dans les procédés actuels par le rapport limité entre la hauteur et la largeur de la sérigraphie de crème à braser ;
- à des procédés manuels ou semi-automatiques de report de cales, qui peuvent être difficilement rendus automatiques ; et
- à d'importants contrôles et inspections de l'assemblage, qui sont requis.

Par ailleurs, on connaît :
- par un article de JONG-KAI LIN intitulé « LOW THERMO-MECHANICAL STRESS FLIP CHIP BUMPS », formant la base du préambule des revendications indépendantes 1 et 8, un procédé de liaison par brasage d'un circuit intégré nu, en AsGa par exemple, et d'un substrat ;
- par le document US 5 906 312, un procédé de fabrication de perle de soudure formée sur une couche d'aluminium déposée sur un substrat ; et
- par le document EP 2 180 505, un procédé de fabrication de boîtier de circuit imprimé nu.

### EXPOSÉ DE L'INVENTION

La présente invention a pour objet de remédier à au moins certains de ces inconvénients. Plus précisément, comme décrit dans la revendication 1, elle concerne un procédé de liaison par brasage entre au moins deux éléments, lesdits deux éléments correspondant respectivement à un circuit imprimé et à un composant électronique, permettant d'augmenter la hauteur des joints brasés et améliorer la tenue en fatigue thermomécanique du dispositif électronique obtenu dans un environnement sévère tel que celui précité.

Ainsi, grâce à l'invention, par la formation des empilements de bossages, on génère une surélévation d'un élément par rapport à l'autre, ce qui permet d'augmenter la hauteur des joints brasés, et ainsi d'accroître la robustesse et plus précisément la tenue en fatigue thermomécanique du dispositif électronique obtenu après la mise en oeuvre dudit procédé.

De façon avantageuse, l'étape de formation consiste à mettre en oeuvre une thermosonie ou soudure thermosonique (« thermosonic bonding » en anglais). Une telle soudure prévoit d'associer pendant une durée déterminée des ultrasons, une force (ou pression d'appui) et une température (de l'ordre de 150°C typiquement). Elle ne nécessite pas de métal d'apport, l'apport de produit de brasage utilisé servant à réaliser les bossages. Plus précisément, l'étape de formation consiste, pour chaque empilement de bossages, à mettre en oeuvre, successivement, un nombre prédéterminé de sous-étapes de formation, chacune desdits sous-étapes de formation consistant à former un bossage, les bossages de chaque empilement de bossages étant formés successivement en étant empilés les uns sur les autres. De préférence, chaque sous-étape de formation (destinée à former un bossage de type plot) comporte au moins les opérations suivantes :
- une opération de chauffage d'un fil métallique par l'intermédiaire d'une électrode ;
- une opération de dépôt d'une bille de métal formée à l'extrémité du fil métallique chauffé ;
- une opération d'écrasement et de soudure de la bille de métal ; et
- une opération de séparation du fil métallique de la bille de métal écrasée pour former le bossage.

### Avantageusement :

- chaque bossage présente une hauteur comprise entre 20 µm et 30 µm pour un fil de diamètre de 25 µm typiquement. La hauteur peut être contrôlée avec une extrême précision inférieure au micromètre, reproductible et répétable grâce à des équipements automatiques ; et/ou
- chaque empilement de bossages présente une hauteur comprise entre 110 µm et 150 µm pour le gain de robustesse visé typiquement (compris entre 80 et 200 selon le nombre de cycles à rupture que le composant doit tenir) ; et/ou
- au moins certains desdits empilements de bossages sont séparés les uns des autres d'une distance comprise entre 0,05 mm et 0,1 mm, sur ledit premier élément.

En outre, de façon avantageuse, les bossages sont réalisés dans l'un des matériaux suivants : du cuivre, de l'or, de l'argent ou du platine, et de préférence en cuivre ou en argent, en particulier pour être adaptés au matériau utilisé pour la brasure.

Dans un mode de réalisation particulier, le procédé comporte une pluralité de suite d'étapes, chacune de ces suites d'étapes permettant de lier un composant électronique sur le même circuit imprimé de manière à obtenir un dispositif électronique comprenant un circuit imprimé pourvu d'une pluralité de composants électroniques.

Dans le cadre de la présente invention, ledit premier élément sur lequel sont formés les empilements de bossages peut être, soit le circuit imprimé, soit le composant électronique.

Ainsi :
- dans un premier mode de réalisation, ledit premier élément correspond au circuit imprimé, et ledit second élément correspondant au composant électronique ; et
- dans un second mode de réalisation, ledit premier élément correspond au composant électronique, et ledit second élément correspondant au circuit imprimé.

La présente invention permet donc d'améliorer la tenue en fatigue de joints brasés par modification de l'interconnexion d'un composant sur un substrat. Plus particulièrement, ledit procédé permet de réaliser une surélévation précise et flexible pour des composants électroniques montés en surface.

La présente invention concerne également un dispositif électronique (formé d'au moins un composant électronique tel qu'un circuit intégré, lié (par brasure à un circuit imprimé) qui est décrit dans la revendication 8.

### BRÈVE DESCRIPTION DES FIGURES

Les figures annexées feront bien comprendre comment l'invention peut être réalisée. Sur ces figures, des références identiques désignent des éléments semblables. Plus particulièrement :
- la figure 1 est le schéma synoptique d'un procédé de liaison selon l'invention ;
- la figure 2 est une vue schématique, en coupe, d'une liaison selon l'invention entre un circuit imprimé et un composant électronique ;
- la figure 3 est une vue, en perspective, d'un exemple de composant électronique apte à être lié à un circuit imprimé ;
- la figure 4 est une vue schématique, en perspective, d'une pluralité d'empilements de bossages ;
- la figure 5 est une vue schématique d'un bossage de type plot réalisé par thermosonie ;
- la figure 6 montre un empilement de deux bossages tels que celui de la figure 5 ;
- la figure 7 montre un empilement de quatre bossages tels que celui de la figure 5 ;
- les figures 8A à 8E montrent schématiquement différentes opérations successives d'une sous-étape de formation d'un bossage de type plot réalisé par thermosonie ;
- la figure 9 est une vue partielle, en perspective, d'un composant électronique pourvu d'une pluralité d'empilements de bossages ;
- la figure 10 est une vue partielle schématique, en perspective, d'un élément pourvu d'une cavité destinée à recevoir des empilements de bossages ; et
- la figure 11 est une vue partielle schématique, en perspective, d'un élément pourvu d'un socle surélevé destiné à recevoir des empilements de bossages.

### DESCRIPTION DÉTAILLÉE

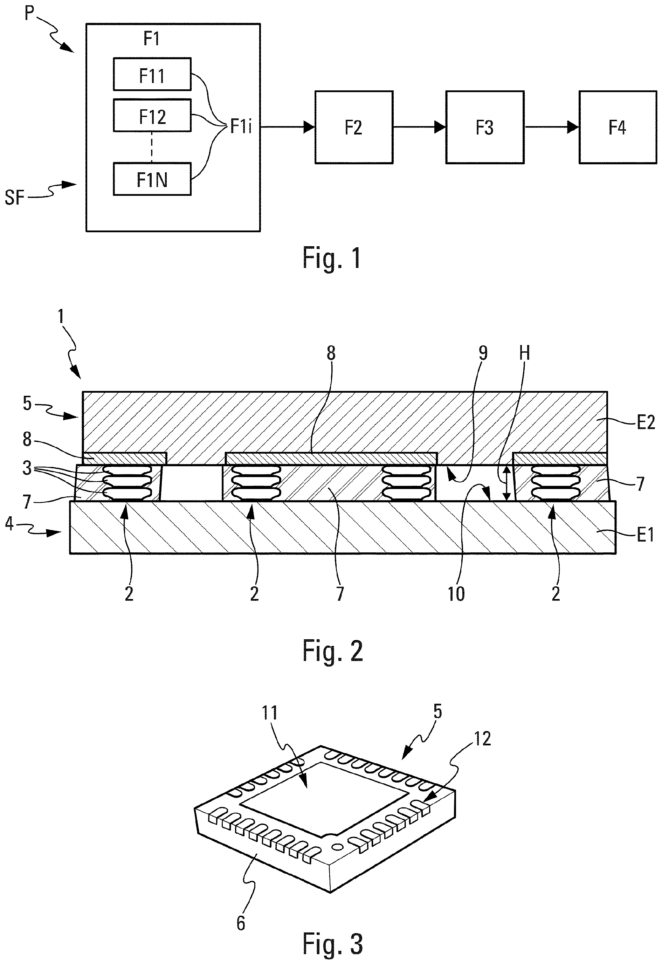

Le procédé P illustrant l'invention et représenté de façon schématique sur la figure 1 est un procédé de liaison (mettant en oeuvre un brasage) dans le domaine de l'assemblage électronique pour générer une liaison entre au moins deux éléments E1 et E2, comme représenté sur la figure 2.

Ces deux éléments E1 et E2 correspondent, l'un à un circuit imprimé 4 (ou carte électronique de type PCB (pour « Printed Circuit Board » en anglais)), et l'autre à un composant électronique 5.

Ce composant électronique 5 peut, notamment, être un circuit imprimé 6 de type QFN (pour « Quad Flat No-leads package » en anglais) comme représenté à titre d'illustration sur la figure 2, de type BGA (« Ball Grid Array » en anglais), ou de type WL CSP (pour « Wafer Level Chip Scale Package» en anglais).

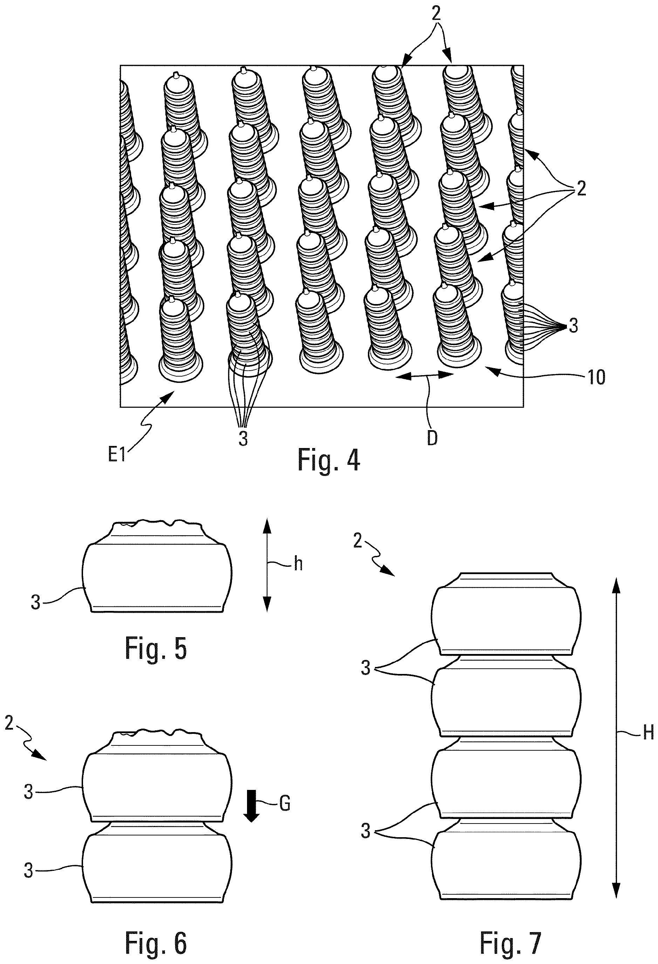

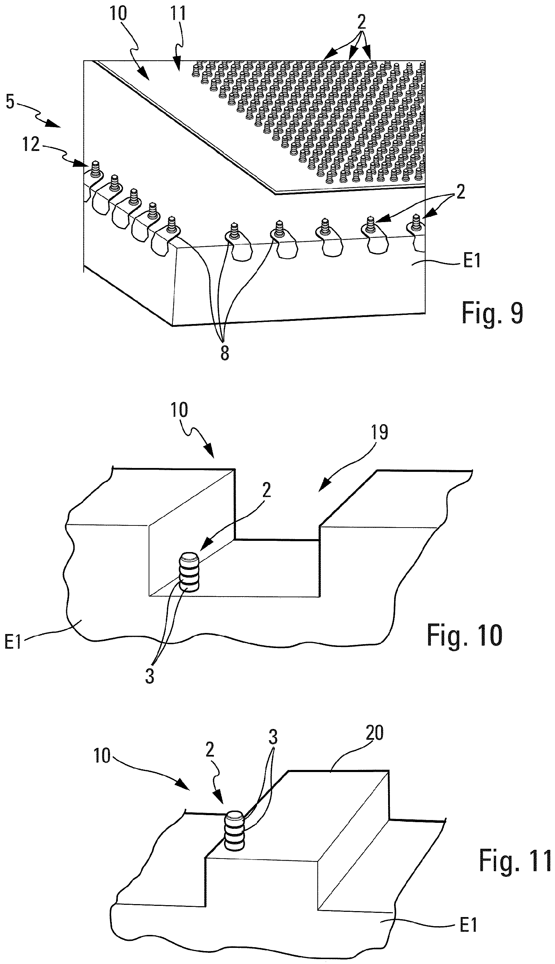

Selon l'invention, ledit procédé P comporte, comme représenté sur la figure 1, au moins la suite d'étapes SF suivante :
- une étape de formation F1 par thermosonie, consistant à former d'une pluralité d'empilements 2 de bossages 3. Ces empilements 2 (de bossages 3) sont formés sur une face 10 d'un premier E1 desdits éléments, comme représenté sur la figure 4. Ce premier élément E1 peut être, soit le circuit imprimé 4 (comme représenté sur la figure 2), soit le composant électronique 5 (comme représenté sur la figure 9), en fonction du mode de réalisation envisagé. Chacun des empilements 2 comprend un même nombre N donné (et prédéterminé) de bossages 3, N étant un entier, comme représenté à titre d'illustration sur la figure 6 (où N est égal à 2) et sur la figure 7 (où N est égal à 4). Les bossages 3 sont de type plot (« stud bump » en anglais), comme montré pour le bossage 3 représenté sur la figure 5 ;
- une étape de dépôt F2 consistant à déposer, de façon usuelle, un produit de brasage 7 (figure 2), conducteur électrique sous forme de pâte, notamment un alliage de brasage, sur ce premier élément E1 pourvu des empilements 2 formés à l'étape de formation F1. On peut également utiliser une colle conductrice électrique à base de résine époxy. A titre d'illustration, le dépôt peut être réalisé par sérigraphie, par dosage par seringue de crème à braser (« dispensing »), ou par jet de microgouttes de crème à braser (« jetting »). On peut également envisager une étape F1 de thermosonie sur l'élément E2 combinée avec une étape de dépôt F2 de façon usuelle sur l'élément E1 ;
- une étape d'agencement F3 consistant à agencer, de façon usuelle, l'autre élément E2 (c'est-à-dire le second E2 desdits éléments E1 et E2) sur ledit premier élément E1, en l'amenant au contact avec l'une 9 de ses faces, au niveau de plages 8, des empilements 2 agencés sur la face 10 du premier élément E1, comme montré sur la figure 2 ; et
- au moins une étape de refusion F4 consistant à réaliser, de façon usuelle, une refusion de l'ensemble ainsi formé (à l'étape d'agencement F3) pour finalement obtenir un ensemble électronique appelé ci-après dispositif électronique 1 (figure 2). Cette refusion est réalisée à une température limitée, de l'ordre de 240° C.

Ainsi, grâce au procédé P, on génère à l'étape de formation F1 une surélévation par la mise en place d'empilements 2 de bossages 3 de type plot, ce qui permet d'augmenter la hauteur des joints brasés du premier élément E1 par rapport au second élément E2, permettant ainsi d'augmenter la robustesse et plus précisément la tenue en fatigue thermomécanique du dispositif électronique 1 obtenu après la mise en oeuvre dudit procédé P.

Ce procédé P permet d'améliorer la tenue en environnement sévère (tel que précité) pour des composants « grand public ». Plus particulièrement, le dispositif électronique 1 ainsi formé est en mesure de tenir un nombre de cycles de température, entre -55°C et +125°C, sur une durée de l'ordre de 25 ans, comme requis dans le domaine militaire.

L'étape de formation F1 consiste, pour chaque empilement 2 de bossages 3, à mettre en oeuvre, successivement, un nombre prédéterminé N de sous-étapes de formation F1i, i variant de 1 à N.

Chacune desdites sous-étapes de formation F11, F12, ..., à F1N successives (figure 1) consiste à former un unique bossage 3, par exemple tel que celui représenté sur la figure 5. Les bossages 3 de chaque empilement 2 sont formés, successivement, l'un après l'autre en étant empilés les uns sur les autres.

A titre d'illustration, sur la figure 6, on a représenté un empilement 2 de deux bossages 3, et sur la figure 7, on a représenté un empilement 2 de quatre bossages 3.

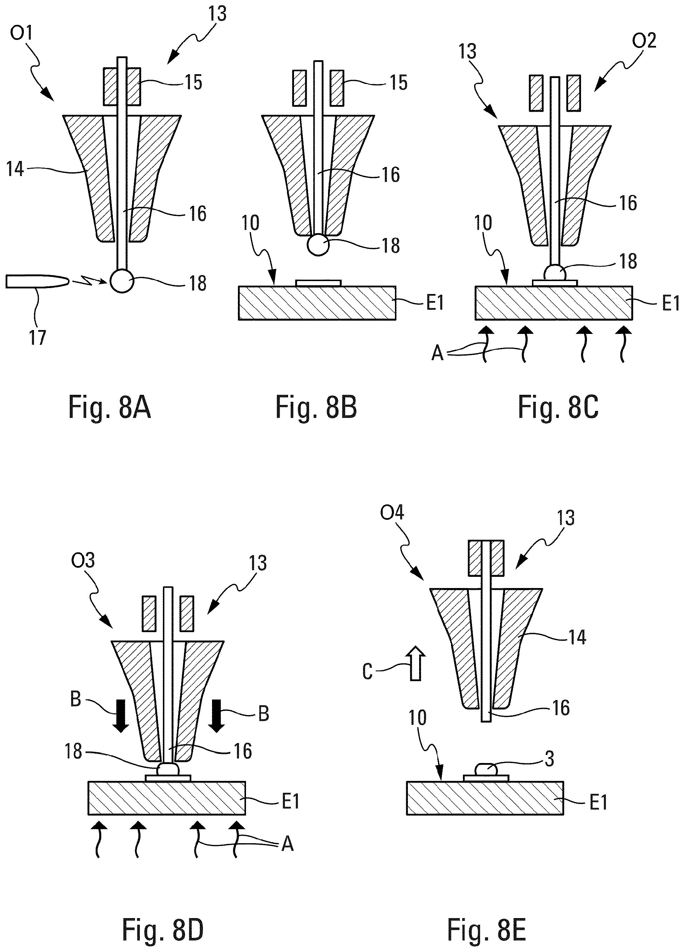

Pour ce faire, dans un mode de réalisation préféré, chaque étape de formation F1i par thermosonie met en oeuvre, comme représenté sur les figures 8A à 8E, les opérations suivantes, à l'aide d'un outil 13 comprenant un corps capillaire 14 et un élément de préhension 15 tel qu'une pince :
- une opération de chauffage O1 consistant à chauffer un fil métallique 16 maintenu dans l'outil 13, par l'intermédiaire d'une électrode 17, comme représenté sur la figure 8A de manière à former une bille (ou boule) de métal 18. Le fil 16 est réalisé dans le métal que l'on souhaite utiliser pour le bossage à former ;
- une opération de dépôt O2 consistant à déposer la bille de métal 18 formée à l'extrémité du fil métallique 16 chauffé, sur la face 10 de l'élément E1 lorsqu'il s'agit du premier bossage de l'empilement, comme représenté sur les figures 8B (dans laquelle l'élément de préhension 15 libère le fil métallique 16 qui remonte) et 8C (qui illustre le dépôt), ou sur un autre bossage déjà formé sur cette face 10. L'élément E1 est soumis à un échauffement illustré par des flèches A. Sur la figure 6, on a représenté, à titre d'illustration, la formation d'un bossage 3 sur un autre bossage 3 déjà formé, avec un dépôt dans le sens illustré par une flèche G. On peut également prévoir un apport d'énergie par ultrasons ;
- une opération d'écrasement et de soudure O3 consistant à générer une force (illustrée par des flèches B sur la figure 8D), une température de 150°C typiquement ainsi que des ultrasons sur la bille de métal 18, à l'aide d'une partie de l'outil 13 de préférence en céramique, de manière à l'aplatir légèrement comme montré sur la figure 8D ; et
- une opération de séparation O4 consistant à séparer le fil métallique 16 de la bille de métal 18 écrasée et retirer l'outil 13 (dans le sens illustré par une flèche C sur la figure 8E, avec un maintien du fil métallique 16 par l'élément de préhension 15) de manière à former le bossage 3. La rupture du fil métallique 16 pour former le bossage 3 a lieu à une zone affectée thermiquement.

Dans le cadre de la présente invention :
- chaque bossage 3 présente une hauteur h (représentée sur la figure 5) qui est comprise entre 20 µm et 30 µm ;
- on peut prévoir un nombre N très varié de bossages 3 par empilement 2, par exemple de 2 à 30 bossages par empilement et de préférence de 3 à 6 bossages par empilement.
- chaque empilement 2 de bossages 3 présente une hauteur H (représentée sur les figures 2 et 7) qui est comprise entre 110 µm et 150 µm.

De plus, avec le procédé P précité, il est possible d'approcher, à courte distance, les empilements 2 les uns des autres, si cela est nécessaire ou souhaité à l'étape de formation F1. Selon l'invention, certains des empilements 2 de bossages sont séparés les uns des autres, sur ledit premier élément E1, d'une distance D (représentée sur la figure 4) qui est comprise entre 0,05 mm et 0,1 mm. Ces caractéristiques peuvent être adaptées selon la matrice du composant ainsi que le nombre de cycles à rupture que le composant doit tenir.

Dans un mode de réalisation particulier, les bossages 3 sont réalisés dans l'un des matériaux suivants : du cuivre, de l'or, de l'argent ou du platine. De préférence, toutefois lesdits bossages 3 sont réalisés en cuivre ou en argent de manière à permettre une meilleure cohésion avec le produit de brasage 7 et évite la dissolution (dans le cas de l'or) du bossage par la brasure.

Le procédé P et notamment l'étape de formation F1 peuvent être intégrés dans des méthodes standard de liaison par brasage. Ainsi, notamment l'étape de dépôt F2 peut être mise en oeuvre de façon usuelle.

Par conséquent, le procédé P, tel que décrit ci-dessus :
- est flexible et adaptable ;
- n'est pas limité par le pas (ou distance) des entrées/sorties (distance D entre les entrées/sorties) ;
- peut être mis en oeuvre avec un contrôle précis et large de la plage de variation de hauteur, avec par exemple 2 à 30 niveaux de bossages 3 empilés (par empilement 2 de bossages) ; et
- permet de limiter les contraintes d'origine thermique pour les éléments E1 et E2 lors des phases d'assemblage. Les contraintes thermiques subies pendant la mise en oeuvre du procédé sont limitées, avec au maximum une température de l'ordre de 150°C lors de l'étape F1 de thermosonie.

Dans un mode de réalisation particulier (non représenté), le procédé P comporte une pluralité de suites d'étapes SF. Chacune de ces suites d'étapes SF est destinée à lier, à chaque fois, un autre composant électronique sur le même circuit imprimé. Ceci permet d'obtenir un dispositif électronique comprenant un unique circuit imprimé pourvu d'une pluralité de composants électroniques.

Par ailleurs, grâce au mode de réalisation du procédé P, les bossages 3 (et donc l'élément E2) peuvent donc être agencés sur un élément E1 dont la face 10 présente une forme sensiblement plane, comme représenté sur la figure 9. De plus, le procédé P tel que décrit ci-dessus permet également de former, de façon avantageuse, des empilements 2 de bossages 3 sur un élément E1 dont la face 10 n'est pas plane, en particulier au niveau d'une cavité 19 de cet élément E1 comme représenté sur la figure 10 ou au niveau d'un socle 20 surélevé de cet élément E1 comme représenté sur la figure 11. Pour des raisons de simplification des dessins, on a représenté un seul de la pluralité d'empilements 2 de bossages 3 sur les figures 10 et 11. Dans ces situations des figures 10 et 11, l'élément E2 est donc agencé dans la cavité 19 ou sur le socle 20.

Comme indiqué ci-dessus, dans le cadre de la présente invention, ledit premier élément E1 sur lequel sont formés les empilements 2 de bossages 3 peut être, soit le circuit imprimé 4, soit le composant électronique 5.

Ainsi :
- dans un premier mode de réalisation, comme représenté sur la figure 2, ledit premier élément E1 correspond au circuit imprimé 4, et ledit second élément E2 correspondant au composant électronique 5 ; et
- dans un second mode de réalisation, ledit premier élément E1 correspond au composant électronique 5 (figure 9), et ledit second élément E2 correspondant au circuit imprimé.

Avec le procédé P, il existe une grande liberté et donc une grande flexibilité concernant le nombre et l'emplacement des empilements sur l'élément E1. En particulier, comme représenté à titre d'illustration sur la figure 9, lorsque l'élément E1 est un composant électronique 5, les empilements 2 peuvent notamment être formés sur la partie centrale 11 de la face 10 du composant électronique 5 et/ou sur la périphérie 12 de cette face 10.

L'empilement 2 de bossages 3 sur un élément E1, par exemple sur un composant électronique 5 tel qu'un circuit intégré, permet donc de le surélever et d'obtenir un maximum de brasure sous cet élément E1. Cet empilement 2 augmente ainsi la hauteur de joint brasé (obtenu aux étapes F3 et F4 à l'aide du produit de brasage 7) et améliore la tenue en fatigue thermomécanique du dispositif électronique 1.

Ainsi, grâce à l'invention, on obtient, un procédé P qui est :
- flexible :
   - en hauteur, en choisissant une hauteur H appropriée par empilement 2 ;
   - en positionnement sur l'élément E1, avec par exemple une formation d'empilements 2 sur des plages de dissipation thermique ou sur des entrées/sorties de l'élément E1 ;
   - en nombre d'empilements 2. A titre d'illustration, on peut prévoir plusieurs milliers d'empilements 2 par élément E1, notamment par composant électronique 5 ; et
- adaptable. Ce procédé P peut être intégré dans les méthodes standard de liaison par brasage, et il est adaptable en fonction des applications liées au composant électronique et au circuit imprimé.

Ce procédé P peut être mis en oeuvre par l'intermédiaire d'un équipement automatique et de méthodes standard existant dans le domaine de l'électronique grand public.

De plus, il existe une possibilité de formation isostatique de trois empilements de bossages ou hyperstatique d'un nombre important d'empilements de bossages.

En outre, ledit procédé P n'a pas d'impact sur les réparations, et il est adaptable à tout type de répartition (ou de design) des empilements.

Par ailleurs, le procédé P est notamment applicable à des composants électroniques présentant :
- des terminaisons sur le bord du composant (« Bottom Terminations Components » en anglais), par exemple de type QFN, DFN, ou LCC ;
- des terminaisons par billes en matrices, par exemple de type BGA ou « flip chip » ;
- des terminaisons par plages sous le composant, par exemple de type LGA.

Le procédé P tel que décrit ci-dessus, qui est donc basé sur la formation d'empilements 2 de bossages 3, présente, notamment, les caractéristiques et avantages suivants :
- une précision microélectronique adaptable aux besoins existant et futurs (distance (ou pas) D de 0,05 mm par exemple) ;
- une température à laquelle est soumis notamment le composant électronique, qui est réduite, de l'ordre de 150°C lors de la thermosonie ;
- une répétabilité de la géométrie en automatisant le procédé ;
- un procédé auto-contrôlable ;
- une flexibilité ;
- un coût maîtrisé ; et
- une augmentation de la densité d'intégration.

Ce procédé est donc principalement adapté pour améliorer la tenue en fatigue des joints brasés. Toutefois, en raison de l'extrême précision, ce procédé peut également remplir des fonctions secondaires d'alignement spécifiques (alignement de fonctions optiques, alignement de fonctions dans trois axes, ....).

## Revendications

1. Procédé de liaison par brasage entre au moins deux éléments (E1, E2), lesdits deux éléments (E1, E2) correspondant respectivement à un circuit imprimé (4) et à un composant électronique (5), ledit procédé comportant au moins la suite d'étapes (SF) suivante :
a) une étape (F1) de formation d'une pluralité d'empilements (2) de bossages (3) de type plot, lesdits empilements (2) de bossages (3) étant formés sur une face (10) d'un premier (E1) desdits éléments (E1, E2), lesdits empilements (2) de bossages (3) comprenant chacun un même nombre donné de bossages (3);
< le procédé étant **caractérisé en ce que** chaque bossage (3) présente une hauteur (h) comprise entre 20 µm et 30 µm, chaque empilement (2) de bossages (3) présente une hauteur (H) comprise entre 110 µm et 150 µm, au moins certains desdits empilements (2) de bossages (3) sont séparés les uns des autres d'une distance (D) comprise entre 0,05 mm et 0,1 mm sur ledit premier élément (E1) ;
et **en ce que** pendant l'étape (F3), ledit deuxième élément (E2) est amené avec l'une (9) de ses faces au contact des empilements (2) agencés sur la face (10) du premier élément (E1). >
b) une étape (F2) de dépôt d'un produit de brasage (7) sur ce premier élément (E1) pourvu des empilements (2) de bossages (3) ;
c) une étape (F3) d'agencement du second (E2) desdits éléments (E1, E2) sur ledit premier élément (E1) ; et
d) une étape (F4) de refusion de l'ensemble ainsi formé à l'étape (F3) d'agencement pour obtenir un dispositif électronique (1); <->

2. Procédé selon la revendication 1,
**caractérisé en ce que** l'étape (F1) de formation consiste, pour chaque empilement (2) de bossages (3), à mettre en oeuvre, successivement, un nombre prédéterminé de sous-étapes de formation (F1i), chacune desdits sous-étapes de formation (F1i) consistant à former un bossage (3), les bossages (3) de chaque empilement (2) de bossages (3) étant formés successivement en étant empilés les uns sur les autres.

3. Procédé selon la revendication 2, **caractérisé en ce que** chaque sous-étape de formation (F1i) comporte au moins les opérations suivantes :
- une opération (O1) de chauffage d'un fil métallique (16) par l'intermédiaire d'une électrode (17) ;
- une opération (O2) de dépôt d'une bille de métal (18) formée à l'extrémité du fil métallique (16) chauffé ;
- une opération (O3) d'écrasement et de soudure de la bille de métal (18) ; et
- une opération (O4) de séparation du fil métallique (16) de la bille de métal (18) écrasée, pour former le bossage (3).

4. Procédé selon l'une quelconque des revendications précédentes, **caractérisé en ce que** les bossages (3) sont réalisés dans l'un des matériaux suivants : de l'or, du cuivre, de l'argent, du platine.

5. Procédé selon l'une quelconque des revendications précédentes, **caractérisé en ce qu'**il comporte une pluralité de suites d'étapes (SF), chacune de ces suites d'étapes (SF) permettant de lier un composant électronique sur le même circuit imprimé de manière à obtenir un dispositif électronique comprenant un seul circuit imprimé pourvu d'une pluralité de composants électroniques.

6. Procédé selon l'une quelconque des revendications 1 à 5,
**caractérisé en ce que** ledit premier élément (E1) correspond au circuit imprimé (4), et ledit second élément (E2) correspondant au composant électronique (5).

7. Procédé selon l'une quelconque des revendications 1 à 5,
**caractérisé en ce que** ledit premier élément (E1) correspond au composant électronique (5), et ledit second élément (E2) correspondant au circuit imprimé (4).

8. Dispositif électronique,
obtenu par la mise en oeuvre du procédé (P) selon l'une quelconque des revendications 1 à 7, ledit dispositif électronique (1) comportant au moins deux éléments (E1, E2), lesdits deux éléments (E1, E2) correspondant respectivement à un circuit imprimé (4) et à un composant électronique (5), ledit dispositif électronique (1) comportant également une pluralité d'empilements (2) de bossages (3) de type plot, lesdits empilements (2) de bossages (3) étant formés sur une face (10) d'un premier (E1) desdits éléments (E1, E2), lesdits empilements (2) de bossages (3) comprenant chacun un même nombre donné de bossage (3),
< le dispositif étant **caractérisé en ce que** chaque bossage (3) présente une hauteur (h) comprise entre 20 µm et 30 µm, chaque empilement (2) de bossages (3) présente une hauteur (H) comprise entre 110 µm et 150 µm, et ledit deuxième élément (E2) contact avec l'une (9) de ses faces, au niveau de plages, les empilements agencés sur la face (10) du premier élément (E1). > ledit dispositif électronique (1) comportant également un produit de brasage (7) déposé sur ce premier élément (E1) pourvu des empilements (2) de bossage (3),
< - >

## Patentansprüche

1. Lötverbindungsverfahren zwischen mindestens zwei Elementen (E1, E2), wobei die zwei Elemente (E1, E2) einer Leiterplatte (4) bzw. einer elektronischen Komponente (5) entsprechen, wobei das Verfahren mindestens die folgende Schrittfolge (SF) umfasst:
a) einen Schritt (F1) der Bildung einer Vielzahl von Stapeln (2) von Vorsprüngen (3) vom Stifttyp, wobei die Stapel (2) von Vorsprüngen (3) auf einer Seite (10) eines ersten (E1) der Elemente (E1, E2) gebildet werden, wobei die Stapel (2) von Vorsprüngen (3) jeweils eine gleiche gegebene Anzahl von Vorsprüngen (3) umfassen;
b) einen Schritt (F2) des Abscheidens eines Lötprodukts (7) auf diesem ersten Element (E1), das mit den Stapeln (2) von Vorsprüngen (3) versehen ist;
c) einen Schritt (F3) des Anordnens des zweiten (E2) der Elemente (E1, E2) auf dem ersten Element (E1); und
d) einen Schritt (F4) der erneuten Verschmelzung der auf diese Weise im Schritt (F3) des Anordnens gebildeten Baugruppe, um eine elektronische Vorrichtung (1) zu erhalten,
wobei das Verfahren **dadurch gekennzeichnet ist, dass** jeder Vorsprung (3) eine Höhe (h) zwischen 20 µm und 30 µm aufweist, jeder Stapel (2) von Vorsprüngen (3) eine Höhe (H) zwischen 110 µm und 150 µm aufweist, mindestens gewisse der Stapel (2) von Vorsprüngen (3) um einen Abstand (D) zwischen 0,05 mm und 0,1 mm auf dem ersten Element (E1) voneinander getrennt sind;
und dadurch, dass das zweite Element (E2) während des Schritts (F3) mit der einen (9) seiner Seiten mit den auf der Seite (10) des ersten Elements (E1) angeordneten Stapeln (2) in Kontakt gebracht wird.

2. Verfahren nach Anspruch 1,
**dadurch gekennzeichnet, dass** der Schritt (F1) der Bildung, für jeden Stapel (2) von Vorsprüngen (3), aus dem sukzessiven Einsetzen einer vorbestimmten Anzahl von Teilschritten der Bildung (F1i) besteht, wobei jeder der Teilschritte der Bildung (F1i) aus dem Bilden eines Vorsprungs (3) besteht, wobei die Vorsprünge (3) jedes Stapels (2) von Vorsprüngen (3) sukzessiv gebildet werden, indem sie aufeinandergestapelt werden.

3. Verfahren nach Anspruch 2,
**dadurch gekennzeichnet, dass** jeder Teilschritt der Bildung (F1i) mindestens die folgenden Vorgänge umfasst:
- einen Vorgang (O1) des Erhitzens eines Metalldrahts (16) mittels einer Elektrode (17);
- einen Vorgang (02) des Abscheidens einer am Ende des erhitzten Metalldrahts (16) gebildeten Metallkugel (18);
- einen Vorgang (03) des Zerdrückens und des Lötens der Metallkugel (18); und
- einen Vorgang (04) des Trennens des Metalldrahts (16) von der zerdrückten Metallkugel (18), um den Vorsprung (3) zu bilden.

4. Verfahren nach einem der vorstehenden Ansprüche,
**dadurch gekennzeichnet, dass** die Vorsprünge (3) aus einem der folgenden Materialien hergestellt sind: Gold, Kupfer, Silber, Platin.

5. Verfahren nach einem der vorstehenden Ansprüche,
**dadurch gekennzeichnet, dass** es eine Vielzahl von Schrittfolgen (SF) umfasst, wobei jede dieser Schrittfolgen (SF) ermöglicht, eine elektronische Komponente derart auf derselben Leiterplatte zu verbinden, dass eine elektronische Vorrichtung erhalten wird, die eine einzige Leiterplatte umfasst, die mit einer Vielzahl von elektronischen Komponenten versehen ist.

6. Verfahren nach einem der Ansprüche 1 bis 5,
**dadurch gekennzeichnet, dass** das erste Element (E1) der Leiterplatte (4) entspricht und das zweite Element (E2) der elektronischen Komponente (5) entspricht.

7. Verfahren nach einem der Ansprüche 1 bis 5,
**dadurch gekennzeichnet, dass** das erste Element (E1) der elektronischen Komponente (5) entspricht und das zweite Element (E2) der Leiterplatte (4) entspricht.

8. Elektronische Vorrichtung,
die durch den Einsatz des Verfahrens (P) nach einem der Ansprüche 1 bis 7 erhalten wird, wobei die elektronische Vorrichtung (1) mindestens zwei Elemente (E1, E2) umfasst,
wobei die zwei Elemente (E1, E2) einer Leiterplatte (4) bzw. einer elektronischen Komponente (5) entsprechen, wobei die elektronische Vorrichtung (1) ebenfalls eine Vielzahl von Stapeln (2) von Vorsprüngen (3) vom Stifttyp umfasst, wobei die Stapel (2) von Vorsprüngen (3) auf einer Seite (10) eines ersten (E1) der Elemente (E1, E2) gebildet sind, wobei die Stapel (2) von Vorsprüngen (3) jeweils eine gegebene gleiche Anzahl von Vorsprüngen (3) umfassen,
wobei die elektronische Vorrichtung (1) ebenfalls ein Lötprodukt (7) umfasst, das auf diesem ersten Element (E1), das mit den Stapeln (2) von Vorsprüngen (3) versehen ist, abgesetzt ist,
wobei die Vorrichtung **dadurch gekennzeichnet ist, dass** jeder Vorsprung (3) eine Höhe (h) zwischen 20 µm und 30 µm aufweist, jeder Stapel (2) von Vorsprüngen (3) eine Höhe (H) zwischen 110 µm und 150 µm aufweist, und das zweite Element (E2) mit der einen (9) seiner Seiten an Bereichen die auf der Seite (10) des ersten Elements (E1) angeordneten Stapel kontaktiert.

## Claims

1. A method for connection, by brazing, between at least two elements (E1, E2), said two elements (E1, E2) corresponding respectively to a printed circuit (4) and to an electronic component (5), said method comprising at least the following sequence of steps (SF):
a) a step (F1) of forming a plurality of stacks (2) of stud bump (3), said stacks (2) of bumps (3) being formed on a face (10) of a first (E1) of said elements (E1, E2), said stacks (2) of bumps (3) each comprising the same given number of bumps (3);
b) a step (F2) of depositing a brazing product (7) on this first element (E1) provided with stacks (2) of bumps (3);
c) a step (F3) of arranging the second (E2) of said elements (E1, E2) on said first element (E1); and
d) a step (F4) of remelting the assembly thus formed in the arranging step (F3), in order to obtain an electronic device (1),
said method being **characterized in that** each bump (3) has a height (h) of between 20 µm and 30 µm, each stack (2) of bumps (3) has a height (H) of between 110 µm and 150 µm, at least some of said stacks (2) of bumps (3) being separated from each other by a distance (D) of between 0.05 mm and 0.1 mm on said first element (E1);
and **in that**, during step (F3), said second element (E2) is brought into contact with one (9) of its faces of the stacks (2) arranged on the face (10) of the first element (E1).

2. The method according to claim 1,
**characterized in that** the forming step (F1) consists, for each stack (2) of bumps (3), in implementing, in succession, a predetermined number of forming sub-steps (F1i), each of said forming sub-steps (F1i) consisting in forming a bump (3), the bumps (3) of each stack (2) of bumps (3) being formed in succession by being stacked on top of each other.

3. The method according to claim 2,
**characterised in that** each forming sub-step (F1i) comprises at least the following operations:
- an operation (O1) of heating of a metal wire (16) by means of an electrode (17);
- an operation (02) of depositing a metal ball (18) formed at the end of the heated metal wire (16);
- an operation (03) of crushing and welding the metal ball (18); and
- an operation (04) of separating the metal wire (16) from the crushed metal ball (18) to form the bump (3).

4. The method according to any one of the preceding claims,
**characterised in that** the bumps (3) are made of one of the following materials: gold, copper, silver, platinum.

5. The method according to any one of the preceding claims,
**characterised in that** it comprises a plurality of sequences of steps (SF), each of these sequences of steps (SF) enabling to connect an electronic component onto the same printed circuit so as to obtain an electronic device comprising a single printed circuit provided with a plurality of electronic components.

6. The method according to any one of claims 1 to 5,
**characterised in that** said first element (E1) corresponds to the printed circuit (4), and said second element (E2) corresponds to the electronic component (5).

7. The method according to any one of claims 1 to 5,
**characterized in that** said first element (E1) corresponds to the electronic component (5), and said second element (E2) corresponds to the printed circuit (4).

8. An electronic device,
obtained by implementing the method (P) according to any one of claims 1 to 7,
said electronic device (1) comprising at least two elements (E1, E2), said two elements (E1, E2) corresponding respectively to a printed circuit (4) and to an electronic component (5), said electronic device (1) also comprising a plurality of stacks (2) of stud bump (3), said stacks (2) of bumps (3) being formed on a face (10) of a first (E1) of said elements (E1, E2), said stacks (2) of bumps (3) each comprising the same given number of bumps (3),
said electronic device (1) also comprising a brazing product (7) deposited on this first element (E1) provided with stacks (2) of bumps (3),
the device being **characterized in that** each bump (3) has a height (h) of between 20 µm and 30 µm, each stack (2) of bumps (3) has a height (H) of between 110 µm and 150 µm, and said second element (E2) being into contact with one (9) of its faces, at the level of ranges, of the stacks (2) arranged on the face (10) of the first element (E1.
